# DEMANDE DE BREVET EUROPEEN

(11) **EP 1 277 852 A1**
(43) Date de publication de la demande: **22.01.2003**
(21) Numéro de dépôt: 02291636.5
(22) Date de dépôt: 01.07.2002
(51) Int. Cl.: C23C 18/16, B29C 45/14, B29C 45/00

(54) **Procede de galvanisation partielle d'une piece obtenue par moulage-injection**

(30) Priorité: 16.07.2001 FR 0109463
(71) Demandeur: ALCATEL, 75008 Paris (FR)
(72) Inventeur: Phu, Marc, 94550 Chevilly Larue (FR); Roche, Emmanuel, 92380 Garches (FR); Cupif, Bertrand, 92160 Antony (FR)
(74) Mandataire: Korakis-Ménager, Sophie

(57) **Abrégé**

Procédé de galvanisation partielle d'une pièce (10) obtenue par moulage-injection, caractérisé en ce que le procédé comporte les étapes suivantes :
- insertion d'un film (15) dans un moule (20);
- injection d'un matériau galvanisable (11) dans le moule (20) ;
- démoulage de la pièce (10) ;
- galvanisation (30) de l'ensemble de la pièce (10) ;
ledit film (15) étant constitué d'un matériau non galvanisable à forte adhésion avec le matériau galvanisable injecté (11).

## Description

La présente invention concerne un procédé de galvanisation d'une pièce de forme et de dimension quelconque, en particulier la galvanisation partielle d'une telle pièce.

La galvanisation est une technique couramment employée dans de nombreuses industries et permet l'obtention de pièces avec une apparence chromée, titane ou dorée par exemple. La galvanisation est essentiellement une réaction de dépôt électrolytique d'un sel métallique sur un métal, généralement pour le préserver de l'oxydation. La galvanisation d'une pièce permet donc d'obtenir une apparence métallisée et non oxydable.

Les pièces galvanisées ne sont pas forcément en métal mais peuvent être constituées d'un autre matériau, par exemple d'un plastique pour des raisons de coûts et de facilité de création des formes. En effet, le plastique constitue un matériau bas coût facile à travailler et toutes sortes de formes de pièce peuvent être obtenues, en particulier avec les techniques connues d'injection de plastique dans un moule. Différentes familles de plastique peuvent être employées pour un moulage-injection, comme le PC (Poly Carbonate), le PET (Poly Ethylène Térephtalate), ou l'ABS (Acrylate Butadiène Styrène) par exemple. En outre, certaines familles de plastique peuvent être galvanisées comme l'ABS par exemple, et d'autres pas comme le PC par exemple.

Ainsi, la galvanisation de pièces en plastique représente de nombreuses applications dans diverses industries, telle que l'industrie automobile, l'industrie des terminaux de radiocommunication ou des assistants personnels ou toute autre industrie nécessitant de donner une apparence métallisée non oxydable à une pièce en plastique.

La galvanisation d'une pièce plastique nécessite essentiellement la réalisation des étapes suivantes : La pièce est plongée dans un bain chimique acide qui attaque le plastique superficiellement et crée des cavités à la surface de la pièce. La pièce est ensuite successivement plongée dans une pluralité de bains métalliques permettant d'une part d'effectuer des dépôts métalliques (par exemple de cuivre et/ou de nickel) dans les cavités superficielles du plastique et d'autre part de réaliser la galvanisation elle-même par dépôt de sels métalliques qui réagissent par électrolyse avec les dépôts métalliques préalablement effectués. Les bains de sels métalliques peuvent être à base de Chrome, de Titane ou d'Or par exemple, selon l'aspect final recherché pour la pièce galvanisée.

Selon les besoins, techniques ou esthétiques, il peut être avantageux qu'une même pièce présente partiellement un aspect non métallisé, plastique par exemple, et partiellement un aspect métallisé, c'est à dire qu'une unique pièce soit partiellement galvanisée.

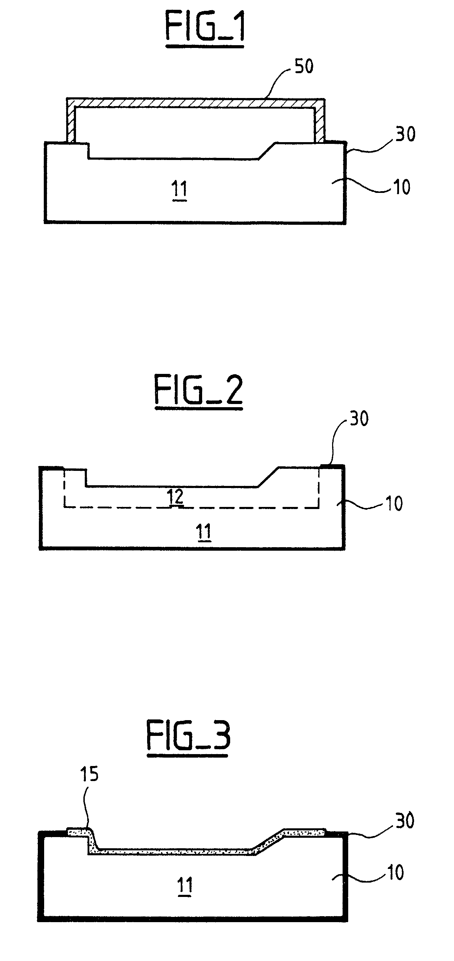

Différentes techniques de galvanisation partielle de pièces ont déjà été proposées dans l'art antérieur. Une première technique, illustrée sur la figure 1, consiste à réaliser une pièce 10 en matériau galvanisable 11 et à utiliser un masque 50 ne laissant apparaître que les zones à galvaniser, puis à plonger la pièce 10 dans les bains de galvanisation 30. Une seconde technique, illustrée sur la figure 2, exposée par exemple dans la demande de brevet EP 0 256 428 A2, consiste à réaliser une pièce 10 constituée d'au moins deux matériaux distincts 11 et 12, un galvanisable 11 et l'autre pas 12, avantageusement par un procédé de bi-injection dans un moule adapté. La pièce est alors intégralement plongée dans les bains de galvanisation, mais un seul type de matériau 11 est attaqué par le bain acide, et donc galvanisé par les bains métalliques 30.

Ces techniques connues de l'art antérieur présentent de nombreux inconvénients. L'utilisation d'un masque ajoute une étape au procédé de fabrication des pièces, ce qui peut être fort nuisible dans des applications de grands volumes. En outre, il est nécessaire de prévoir des points de fixation du masque sur la pièce à galvaniser, ce qui peut nuire à l'esthétique globale de la pièce et présenter une difficulté dans le cas de pièces de petites tailles.

La technique de la bi-injection est complexe de par la nécessité de manipuler deux matériaux différents. De plus les moules utilisés dans le cadre de la bi-injection sont beaucoup plus complexes que ceux utilisés pour une injection avec un unique matériau.

Or, la galvanisation partielle, en particulier de pièces en plastique, tend à se développer surtout dans les industries qui exploitent le design comme argument commercial. Elle permet de fabriquer des pièces avec des matériaux bas coût présentant des portions de surface d'aspect métallisé (chromé par exemple) dans la continuité de portions de surface en plastique par exemple.

L'invention peut ainsi être appliquée à un terminal de radiocommunication, tel qu'un radiotéléphone ou un assistant personnel, constitué d'une coque en plastique qui peut être partiellement galvanisée. L'invention peut également trouver une application dans une pièce pour véhicule automobile en plastique partiellement galvanisée.

Parvenir à réaliser une galvanisation partielle d'une même pièce plastique présente donc un grand intérêt. L'invention en objet propose un tel procédé qui s'affranchit des inconvénients de l'art antérieur.

La présente invention concerne plus particulièrement un procédé de galvanisation partielle d'une pièce obtenue par moulage-injection, caractérisé en ce que le procédé comporte les étapes suivantes :
- insertion d'un film dans un moule;
- injection d'un matériau galvanisable dans le moule ;
- démoulage de la pièce ;
- galvanisation de l'ensemble de la pièce ;
ledit film étant constitué d'un matériau non galvanisable à forte adhésion avec le matériau galvanisable injecté.

Selon une caractéristique avantageuse, le procédé selon l'invention comporte une étape de teinture et/ou d'impression du film préalablement à son insertion dans le moule.

Selon les modes de réalisation, l'impression du film est réalisée par sérigraphie ou par jet d'encre.

Selon les modes de réalisation, l'impression du film est réalisée sur la face externe du film ou sur la face interne du film en contact avec le matériau injecté, ledit film étant alors constitué d'un matériau transparent.

Selon les modes de réalisation, le film est en Poly Carbonate (PC), en Poly Butylène téréphtalate (PBT) ou en Poly Méthacrylate de méthyle (PMMA).

Selon une caractéristique, le matériau injecté dans le moule pour constituer la pièce est un plastique, avantageusement de l'Acrylate Butadiène Styrène (ABS) ou de l'Acrylate Butadiène Styrène / Poly Carbonate (ABS/PC).

L'invention concerne également une pièce constituée d'un matériau galvanisable dont la surface apparente est partiellement galvanisée, caractérisée en ce que la portion de surface apparente non galvanisée est recouverte d'un film en matériau non galvanisable à forte adhésion avec le matériau galvanisable constituant la pièce.

Selon une caractéristique, le film recouvrant la portion de surface apparente non métallisée porte une décoration.

Selon les variantes de réalisation, la décoration est une teinture et/ou une impression.

Selon une caractéristique, la pièce partiellement galvanisée est en plastique, avantageusement en Acrylate Butadiène Styrène (ABS) ou en Acrylate Butadiène Styrène / Poly Carbonate (ABS/PC).

Selon une application, l'invention concerne un terminal de radiocommunication comprenant une coque dont la surface extérieure est partiellement galvanisée, caractérisé en ce que la portion de surface non galvanisée de la coque est recouverte d'un film en matériau non galvanisable à forte adhésion avec le matériau constituant la coque.

Les particularités et avantages de l'invention ressortiront plus clairement à la lecture de la description qui suit, faite à titre d'exemple illustratif et non limitatif, en référence aux figures annexées dans lesquelles :
- la figure 1, déjà décrite, illustre une pièce galvanisée selon une première technique de l'art antérieur ;
- la figure 2, déjà décrite, illustre une pièce galvanisée selon une seconde technique de l'art antérieur ;
- la figure 3 illustre une pièce galvanisée selon le procédé de l'invention ;
- les figures 4a et 4b illustrent des étapes du procédé de moulage injection selon l'invention.

En référence à la figure 3, une pièce 10 est galvanisée 30 partiellement. La pièce 10 est constituée d'un matériau galvanisable 11, par exemple un plastique tel que de l'Acrylate Butadiène Styrène (ABS) ou de l'Acrylate Butadiène Styrène / Poly Carbonate (ABS/PC), qui peut être attaqué par des bains d'acide pour permettre un dépôt de particules métalliques et une réaction de galvanisation par dépôt de sels métalliques, tel que cela a déjà été décrit en référence à l'art antérieur. La pièce 10 a avantageusement été réalisée selon une technique classique de moulage-injection qui permet d'obtenir pratiquement n'importe quelle forme de pièce.

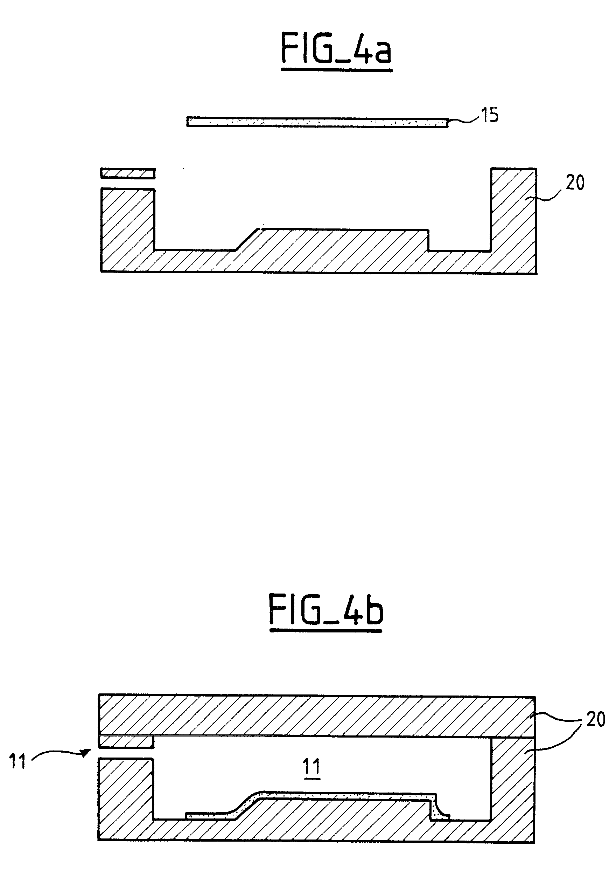

La pièce 10 doit être galvanisée 30 uniquement sur une certaine portion de surface apparente. A cette fin, selon l'invention, un film 15 est inséré dans le moule 20 utilisé pour le moulage-injection de la pièce. Comme illustré sur les figures 4a et 4b, le film 15 est inséré préalablement à l'injection du matériau 11 (plastique ou autre), bien plaqué sur les parois du moule 20 pour éviter tout risque de décalage ou de pli lors de l'injection sous pression du matériau 11 dans le moule. Le film 15 peut être déposé manuellement ou par robot, selon l'industrie en cause.

Le film 15 doit être constitué d'un matériau non galvanisable, tel qu'un plastique en Poly-Carbonate (PC), en Poly Butylène téréphtalate (PBT) ou en Poly Méthacrylate de méthyle (PMMA) par exemple, et doit être compatible avec le matériau injecté 11 pour constituer la pièce 10. En particulier, le matériau du film 15 doit présenter une bonne adhésion avec le matériau injecté 11. En outre, il est préférable que le film 15 soit relativement fin pour ne pas modifier la forme de la pièce imposée par le moule.

Selon une particularité de la présente invention, le film 15 est avantageusement décoré avant son insertion dans le moule 20. La décoration peut consister dans une teinture donnant une coloration particulière de la portion de surface apparente non galvanisée de la pièce 10. La décoration peut également consister dans une impression, par exemple d'un logo, d'un texte ou autre, réalisée selon des techniques classiques de sérigraphie ou de jets d'encre. Selon les modes de réalisation et les applications, la décoration peut être apposée sur la surface interne du film en contact avec le matériau injecté, le film étant alors transparent, ou sur la surface externe du film. Préférentiellement, la décoration sera réalisée sur la surface interne du film afin de la protéger de l'abrasion et d'assurer une meilleure tenue au temps.

Après le moulage-injection et le démoulage de la pièce, réalisés selon des techniques classiques, la pièce 10 incorporant le film 15 est galvanisée intégralement, c'est à dire sans utilisation de masques ou d'autres protections.

Les bains acides attaquent le matériau 11 constituant la pièce 10 mais pas le film 15. Des cavités pour les dépôts métalliques ne se formeront donc que sur la surface de la pièce 10 non protégée par le film 15, et la réaction de galvanisation ne pourra pas se faire sur la portion de surface de la pièce couverte par le film 15. On obtient ainsi une pièce 10 partiellement galvanisée comprenant une portion de surface apparente non métallisée et une portion de surface apparente métallisée, les surfaces de ces deux portions étant dans la continuité l'une de l'autre et la portion de surface apparente non métallisée étant avantageusement recouverte d'un film décoré.

Le procédé selon l'invention allie donc la fonction de galvanisation partielle d'une pièce avec une possibilité de décoration de la pièce. En outre, le procédé est facile à mettre en oeuvre et peu coûteux à implémenter au niveau d'une production industrielle de masse.

## Revendications

1. Procédé de galvanisation partielle d'une pièce (10) obtenue par moulage-injection, **caractérisé en ce que** le procédé comporte les étapes suivantes :
- insertion d'un film (15) dans un moule (20);
- injection d'un matériau galvanisable (11) dans le moule (20) ;
- démoulage de la pièce (10) ;
- galvanisation (30) de l'ensemble de la pièce (10) ;
ledit film (15) étant constitué d'un matériau non galvanisable à forte adhésion avec le matériau galvanisable injecté (11).

2. Procédé de galvanisation selon la revendication 1, **caractérisé en ce qu'**il comporte une étape de teinture et/ou d'impression du film (15) préalablement à son insertion dans le moule.

3. Procédé de galvanisation selon la revendication 2, **caractérisé en ce que** l'impression du film est réalisée par sérigraphie ou par jet d'encre.

4. Procédé de galvanisation selon la revendication 2, **caractérisé en ce que** l'impression du film est réalisée sur la face interne du film en contact avec le matériau injecté, ledit film étant constitué d'un matériau transparent.

5. Procédé de galvanisation selon la revendication 2, **caractérisé en ce que** l'impression du film est réalisée sur la face externe du film.

6. Procédé de galvanisation selon l'une quelconque des revendications précédentes, **caractérisé en ce que** le film (15) est en Poly-Carbonate (PC) ou en Poly Butylène téréphtalate (PBT) ou en Poly Méthacrylate de méthyle (PMMA).

7. Procédé de galvanisation selon l'une quelconque des revendications précédentes, **caractérisé en ce que** le matériau galvanisable (11) injecté dans le moule (20) pour constituer la pièce (10) est un plastique.

8. Procédé de galvanisation selon la revendication 7, **caractérisé en ce que** le plastique injecté dans le moule pour constituer la pièce (10) est de l'Acrylate Butadiène Styrène (ABS) ou de l'Acrylate Butadiène Styrène / Poly Carbonate (ABS/PC).

9. Pièce (10) constituée d'un matériau galvanisable (11) dont la surface apparente est partiellement galvanisée (30), **caractérisée en ce que** la portion de surface apparente non galvanisée est recouverte d'un film (15) en matériau non galvanisable à forte adhésion avec le matériau (11) galvanisable constituant la pièce.

10. Pièce selon la revendication 9, **caractérisé en ce que** le film (15) recouvrant la portion de surface apparente non galvanisée porte une décoration.

11. Pièce selon la revendication 10, **caractérisé en ce que** la décoration est une teinture et/ou une impression.

12. Pièce selon l'une quelconque des revendications 9 à 11, **caractérisée en ce que** le matériau (11) constituant la pièce (10) est un plastique.

13. Pièce selon la revendication 12, **caractérisé en ce que** le plastique constituant la pièce (10) est de l'Acrylate Butadiène Styrène (ABS) ou de l'Acrylate Butadiène Styrène /Poly Carbonate (ABS/PC).

14. Terminal de radiocommunication comprenant une coque dont la surface extérieure est partiellement galvanisée, **caractérisé en ce que** la portion de surface non galvanisée de la coque est recouverte d'un film en matériau non galvanisable à forte adhésion avec le matériau constituant la coque
